# EUROPÄISCHE PATENTANMELDUNG

(11) **EP 2 741 089 A2**
(43) Veröffentlichungstag der Anmeldung: **11.06.2014**
(21) Anmeldenummer: 13193526.4
(22) Anmeldetag: 19.11.2013
(51) Int. Cl.: G01R 1/20, G01R 27/18

(54) **Isolationsüberwachungsgerät mit Messkreistrennung**

(30) Priorität: 04.12.2012 DE 102012222251
(71) Anmelder: Bender GmbH & Co. KG, 35305 Grünberg (DE)
(72) Erfinder: HOFHEINZ, Wolfgang, D-35305 Grünberg (DE)
(74) Vertreter: advotec.

(57) **Zusammenfassung**

Die Erfindung betrifft ein Isolationsüberwachungsgerät, welches zur Überwachung eines Isolationswiderstands mit einem ungeerdeten IT-Stromversorgungssystem einen Messkreis ausbildet, wobei der Messkreis durch eine in dem Isolationsüberwachungsgerät angeordnete Unterbrechervorrichtung aufgetrennt werden kann.

Weiterhin betrifft die Erfindung ein Verfahren zur Durchführung einer Erst- und/oder Wiederholungsprüfung eines Isolationswiderstands in einem ungeerdeten IT-Stromversorgungssystem sowie zur Überwachung des Isolationswiderstands mit einem Isolationsüberwachungsgerät. Zur Durchführung der Erst- und/oder Wiederholungsprüfung erfolgt die Auftrennung des Messkreises durch eine manuelle Schalthandlung, die eine in dem Isolationsüberwachungsgerät angeordnete Unterbrechervorrichtung aktiviert.

## Beschreibung

Die Erfindung betrifft ein Isolationsüberwachungsgerät, welches zwischen aktiven Leitern eines IT-Stromversorgungssystems und einem Schutzleiter angeschlossen ist und zur Überwachung eines Isolationswiderstands mit dem ungeerdeten IT-Stromversorgungssystem einen Messkreis ausbildet.

Weiterhin betrifft die Erfindung ein Verfahren zur Durchführung einer Erst- und/oder Wiederholungsprüfung eines Isolationswiderstands in einem ungeerdeten IT-Stromversorgungssystem sowie zur Überwachung des Isolationswiderstands mit einem Isolationsüberwachungsgerät, welches zwischen aktiven Leitern des IT-Stromversorgungssystems und einem Schutzleiter angeschlossen ist, umfassend die Verfahrensschritte: Durchführen der Erst- und Wiederholungsprüfung, wobei ein aus dem Isolationsüberwachungsgerät und dem IT-Stromversorgungssystem gebildeter Messkreis aufgetrennt wird, und Überwachen des Isolationswiderstands durch das Isolationsüberwachungsgerät, wobei der Messkreis geschlossen ist.

Um eine hohe Verfügbarkeit und Betriebssicherheit der elektrischen Stromversorgung sicherzustellen sowie die Personensicherheit im Bereich elektrischer Anlagen zu gewährleisten, kommen in zunehmendem Maße Stromversorgungsnetze zum Einsatz, deren aktive Leiter von dem Erdpotential getrennt sind. Als Beispiele sind hier Operationsräume in medizinisch genutzten Bereichen, Photovoltaikanlagen oder Hilfsstromkreise für Maschinenanlagen und bahntechnische Anlagen zu nennen.

Bei dieser als ungeerdetes IT-System bezeichneten Art des Stromversorgungsnetzes kann ein aktiver Leiter einen Isolationsfehler aufweisen, ohne dass der laufende Betrieb der Anlage unterbrochen werden muss, weil sich wegen des im Idealfall unendlich großen Impedanzwertes zwischen Leiter und Erde in diesem ersten Fehlerfall kein geschlossener Stromkreis ausbilden kann.

Aus dieser Betrachtung geht hervor, dass der Isolationswiderstand in dem zu überwachenden Netz, einschließlich der Isolationswiderstände aller daran angeschlossenen Betriebsmittel gegen Erde (Isolationswiderstand) ständig überwacht werden muss - festgelegt in der Norm DIN VDE 0100-410 (VDE 0100-410). Mit einer ständigen Isolationsüberwachung des ungeerdeten IT-Systems kann ein Absinken des Isolationswiderstands rechtzeitig erkannt und gemeldet werden.

Daneben enthält die Norm DIN VDE 0100-600 (VDE 0100-600) Anforderungen an eine Erstprüfung nach Fertigstellung einer neuen elektrischen Anlage oder nach Erweiterungen oder Änderungen bestehender Anlagen durch Besichtigen, Erproben und Messen. Beim Erproben ist gemäß Abschnitt 61.3.1 b) der Norm DIN VDE 0100-600 (VDE 0100-600) der Isolationswiderstand der Anlage zu messen. Diese Messung ist mit Gleichspannungen von 250V bis 1000V durchzuführen, wobei die Wahl der Messspannung in Abhängigkeit von der Höhe der Netznennspannung der zu überprüfenden Anlage erfolgt. Da die Isolationswiderstandsmessung mit vorgegebener Genauigkeit erfolgen muss, ist, um Messwertverfälschungen zu vermeiden, bei der Messung von IT-Systemen das normgemäß vorgeschriebene und somit eingebaute Isolationsüberwachungsgerät - mit seinem eigenen Wechsel- bzw. Gleichstromwiderstand (Zᵢ, Rᵢ) nach DIN EN 61557-8 - von Erde, bzw. dem Schutzleiteranschluss zu trennen. Andererseits kann, falls die Trennung des Isolationswiderstandmessgerätes unterbleibt, eine Beschädigung des Gerätes nicht ausgeschlossen werden.

Die Arbeiten zur Trennung des Isolationsüberwachungsgerätes erfordern einen erheblichen zeitlichen und handwerklichen Aufwand und dürfen nur von einer Elektrofachkraft ausgeführt werden. Nach Abschluss der Erst- und gegebenenfalls einer Wiederholungsprüfung ist das Isolationsüberwachungsgerät wieder ordnungsgemäß anzuschließen, um dem geforderten Schutzziel nach der Norm DIN VDE 0100-410 (VDE 0100-410) zu genügen und eine ständige Überwachung des Isolationswiderstands zu gewährleisten.

Bislang wurde der Mehraufwand bei der Erstprüfung der elektrischen Anlage in den meisten Fällen in Kauf genommen. Unterbleibt eine Trennung des Isolationsüberwachungsgerätes, so zeigt sich, - abgesehen von einer möglichen Beschädigung des Gerätes - , dass bedingt durch den Wechsel- bzw. Gleichstrom-Innenwiderstand des Isolationsüberwachungsgerätes eine Prüfung des tatsächlichen Isolationswiderstands nicht möglich ist oder verfälschte Messwerte die Prüfung unbrauchbar machen.

Der vorliegenden Erfindung liegt somit die Aufgabe zu Grunde, die Messung des Isolationswiderstands eines normgerecht installierten, ungeerdeten IT-Stromversorgungssystems im Rahmen einer Erstprüfung hinsichtlich des Arbeitsaufwandes effektiver und zuverlässiger durchzuführen.

Die Aufgabe wird in Verbindung mit dem Oberbegriff des Anspruchs 1 gelöst durch eine in dem Isolationsüberwachungsgerät angeordnete Unterbrechervorrichtung zur Auftrennung des Messkreises.

Erfindungsgemäß weist das Isolationsüberwachungsgerät eine in einer gemeinsamen baulichen Einheit angeordnete Unterbrechervorrichtung auf, die eine Auftrennung des aus Isolationsüberwachungsgerät und IT-System gebildeten Messkreises bewirkt. Durch Aktivierung der Unterbrechervorrichtung wird die durch das Isolationsüberwachungsgerät gebildete Verbindung zwischen den aktiven Leitern des Netzes und dem Schutzleiter aufgetrennt. Damit entfallen die bei der Messung des tatsächlichen Isolationswiderstands im Rahmen einer Erstprüfung des ungeerdeten IT-Stromversorgungssystems erforderlichen Klemmarbeiten, um das Isolationsüberwachungsgerät von den aktiven Leitern oder dem Schutzleiter abzutrennen und nach erfolgter Prüfung wieder anzuschließen. Neben der damit einhergehenden Zeitersparnis wird die elektrische Sicherheit des IT-Systems erhöht, da menschliches Fehlverhalten durch unzulänglich ausgeführte An- und Abklemmarbeiten weitgehend ausgeschlossen ist.

Das erfindungsgemäße Isolationsüberwachungsgerät mit integrierter Unterbrechervorrichtung kann über die Anwendung bei einer Erstprüfung hinaus auch bei der Durchführung von Wiederholungsprüfungen nach DIN VDE 0105-100/A1 (VDE 0105-100/A1) mit Vorteil eingesetzt werden.

In weiterer Ausgestaltung weist die Unterbrechervorrichtung als Schaltmittel einen Relaiskontakt oder ein elektronisches Halbleiter-Schaltelement auf. Die Trennung der elektrischen Verbindung zwischen dem Isolationsüberwachungsgerät und dem Schutzleiter erfolgt vorzugsweise durch ein oder mehrere Relaiskontakte. Alternativ dazu kann die Trennung des Messkreises auch durch einen oder mehrere elektronische Halbleiter-Schaltelemente ausgeführt werden.

Mit Vorteil ist das Schaltmittel der Unterbrechervorrichtung redundant ausgeführt. Aus Sicherheitsüberlegungen heraus können die Schaltmittel redundant ausgelegt sein.

Als zweckmäßig erweist es sich, an dem Isolationsüberwachungsgerät eine Eingabevorrichtung zur manuellen Eingabe einer Schaltinformation vorzusehen, die die Auftrennung und/oder ein Schließen des Messkreises durch die Unterbrechervorrichtung veranlasst. Über die Eingabevorrichtung kann die Unterbrechervorrichtung aktiviert oder deaktiviert werden und somit das Auftrennen oder das Schließen des Isolationsüberwachungsgeräte-Messkreises bewirken. In einfacher Ausführung ist die Eingabevorrichtung ein Schalter oder Taster und die Schaltinformation besteht nur aus einem einmaligen Schaltimpuls. Aus Sicherheitserwägungen heraus und um Fehlaktivierungen zu vermeiden kann zur Eingabe einer definierten Zeichenfolge eine Tastatur in Verbindung mit der Eingabe einer Tastenkombination oder ein berührungsempfindlicher Bildschirm vorgesehen sein.

In Ergänzung zu der manuellen Eingabe an dem Isolationsüberwachungsgerät erweist sich eine Schnittstelle für die Übertragung eines externen Signals zur Auftrennung und/oder zum Schließen des Messkreises durch die Unterbrechervorrichtung von Vorteil. Mit der Übertragung eines externen Signals über die in dem Isolationsüberwachungsgerät angeordnete Schnittstelle können die Auftrennung und/oder das Schließen des Messkreises beispielsweise ferngesteuert von einer übergeordneten Leitstelle aus erfolgen.

Mit Vorteil weist das Isolationsüberwachungsgerät einen elektrischen Energiespeicher auf, der vorzugsweise als Kondensator oder als Batterie ausgeführt ist. Da die im Rahmen der Erst- oder Wiederholungsprüfung vorgenommene Isolationswiderstandsmessung in abgeschaltetem Zustand der elektrischen Anlage erfolgt, muss es möglich sein, das Isolationsüberwachungsgerät auch in spannungslosem Zustand des IT-Stromversorgungssystems abzutrennen. Zu diesem Zweck sind in das Isolationsüberwachungsgerät elektrische Energiespeicher wie Batterien oder Kondensatoren einzubauen.

Bevorzugt umfasst das Isolationsüberwachungsgerät eine Signal- und Steuereinheit, die den aufgetrennten Zustand des Messkreises signalisiert. Eine Signal- und Steuereinheit ist vorgesehen, um während der Erst- oder Wiederholungsprüfung den aufgetrennten Zustand des Messkreises, also ein abgekoppeltes Isolationsüberwachungsgerät, zu signalisieren und gegebenenfalls einen Warnhinweis auszugeben.

Weiterhin ist die Signal- und Steuereinheit derart ausgeführt, dass sie ein automatisches Schließen des Messkreises bewirkt. Die Signal- und Steuereinheit kann somit die Aufgabe übernehmen, beispielsweise zeitgesteuert ein Schließen des Messkreises, also eine Wiederaufschaltung des Isolationsüberwachungsgerätes vorzunehmen, um die geforderte ständige Überwachung des Isolationswiderstands sicherzustellen.

Bezogen auf ein Verfahren wird die zu Grunde liegende Aufgabe in Verbindung mit dem Oberbegriff des Anspruchs 10 dadurch gelöst, dass zur Durchführung der Erst- und/oder Wiederholungsprüfung die Auftrennung des Messkreises durch eine manuelle Schalthandlung erfolgt, die eine in dem Isolationsüberwachungsgerät angeordnete Unterbrechervorrichtung aktiviert.

Der Grundgedanke der vorliegenden Erfindung beruht darauf, durch eine unkomplizierte manuelle Schalthandlung die Trennung des Isolationsüberwachungsgerätes zu aktivieren, anstatt umfangreiche und zeitaufwändige Klemmarbeiten vorzunehmen. Im Gegensatz zur Klemmarbeiten erfordert die Schalthandlung keinen großen zeitlichen und handwerklichen Aufwand und führt somit bei der Erst- und Wiederholungsprüfung der elektrischen Anlage zu einer Zeit- und Kostenersparnis. Da die eigentliche Auftrennung des Messkreises durch die integrierte Unterbrechervorrichtung und nicht durch manuelle Klemmarbeiten erfolgt, ist auch sichergestellt, dass das Isolationsüberwachungsgerät vollständig von den aktiven Leitern und/oder dem Schutzleiter getrennt und nach der Erst- und Wiederholungsprüfung wieder ordnungsgemäß verbunden wird.

Bevorzugterweise erfolgt die manuelle Schalthandlung durch Eingabe einer Schaltinformation an dem Isolationsüberwachungsgerät. Die Schalthandlung kann beispielsweise in dem Betätigen eines Schalters oder Tasters bestehen oder sie kann durch die Eingabe einer Zeichenfolge auf einer Eingabetastatur oder an einem berührungsempfindlichen Bildschirm erfolgen.

Als Vorteil erweist es sich, wenn die manuelle Schalthandlung entfernt mit einem Signal erfolgt, das über eine Schnittstelle von dem Isolationsüberwachungsgerät empfangen wird. Auf diese Weise kann die Trennung des Messkreises von einem von dem Einbauort des Isolationsüberwachungsgerätes entfernten Ort, beispielsweise einer zentralen Leitstelle aus, ausgelöst werden.

Zweckmäßigerweise wird der aufgetrennte Zustand des Messkreises signalisiert. Somit ist der Anlagenbetreiber stets über den Überwachungszustand der elektrischen Anlage informiert und wird auf eine Wiederzuschaltung des Isolationsüberwachungsgerätes aufmerksam gemacht.

Die Signalisierung kann außer über eine Signaleinrichtung an dem Isolationsüberwachungsgerät selbst auch über vorgenannte Schnittstelle weitergeleitet werden, um beispielsweise zentral zu erfassen, welche Anlagenabschnitte momentan nicht einer ständigen Isolationswiderstandsüberwachung unterliegen.

In weiterer Ausgestaltung erfolgt ein automatisches Schließen des Messkreises. Alternativ zu einer manuell ausgeführten Wiederzuschaltung des Isolationsüberwachungsgerätes kann eine automatische Wiederzuschaltung vorgenommen werden, die beispielsweise auf einer Zeitsteuerung basiert.

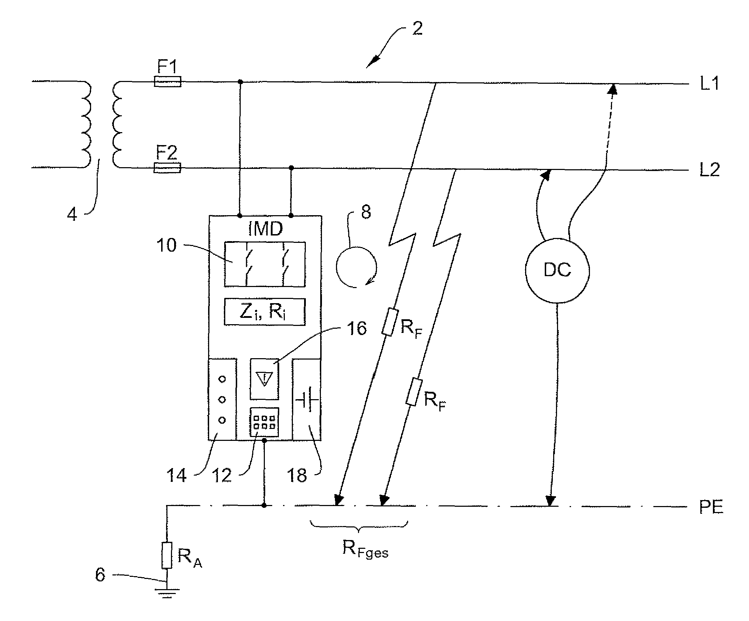

Weitere vorteilhafte Ausgestaltungsmerkmale ergeben sich aus der nachfolgenden Beschreibung und der Zeichnung, die eine bevorzugte Ausführungsform der Erfindung an Hand eines Beispiels erläutert. Es zeigt die
- **Fig. 1:**: ein Prinzipschaltbild der Isolationsüberwachung mit Erstprüfung eines ungeerdeten IT-Stromversorgungssystems.

In dem Prinzipschaltbild nach **Fig. 1** ist ein ungeerdetes IT-Stromversorgungssystem 2 mit zwei aktiven Leitern L1 und L2 dargestellt, die jeweils ein Sicherungselement F1, F2 aufweisen und über einen Transformator 4 gespeist werden. Die aktiven Leiter L1, L2 sind gegen den Schutzleiter PE (Erde) isoliert, so dass sich im Idealfall zwischen dem jeweiligen Leiter L1, L2 und Erde PE ein unendlich großer, als Isolationswiderstand R_{F} - im Fehlerfall auch als Isolationsfehler R_{F} - bezeichneter Impedanzwert einstellt. Der Schutzleiter ist über einen Erder 6 mit dem Erdreich verbunden und bildet zusammen mit dem Widerstand des Erders einen Erdungswiderstand R_{A}.

In der Praxis stellt sich ein tatsächlicher Gesamtisolationswiderstand R_{Fges} ein, der gemäß der Norm DIN VDE 0100-600 (VDE 0100-600) nach Fertigstellung einer neuen elektrischen Anlage einer Erstprüfung unterliegt. Diese Erstprüfung findet in Abhängigkeit der Netznennspannung mit einer Gleichspannung DC von 250 V bis 1000 V statt und ist in dem rechten Teil des dargestellten IT-Stromversorgungssystems symbolisiert, wobei sich der tatsächliche Gesamtisolationswiderstand R_{Fges} aus der Parallelschaltung der Isolationsfehler (Isolationswiderstände) R_{F} ergibt.

Die Fig. 1 zeigt weiterhin ein erfindungsgemäßes Isolationsüberwachungsgerät IMD, das mit den Leitern L1, L2 und dem Schutzleiter PE verbunden ist und der ständigen Überwachung des Isolationswiderstands R_{F} dient, um ein die Sicherheit gefährdendes Absinken des Isolationswiderstands R_{F} frühzeitig zu erkennen. Das Isolationsüberwachungsgerät IMD bildet gemeinsam mit dem IT-Stromversorgungssystem 2 einschließlich des Gesamtisolationswiderstands R_{Fges} einen Messkreis 8, in dem sich ein auswertbarer Messstrom entsprechend dem Gesamtisolationswiderstand R_{Fges} einstellt.

Da das Isolationsüberwachungsgerät IMD einen komplexwertigen Innenwiderstand Zᵢ mit einem ohmschen Anteil Rᵢ aufweist, kann der Messwert des im Rahmen der Erstprüfung zu ermittelnden tatsächlichen Gesamtisolationswiderstands R_{Fges} erheblich verfälscht werden, falls der Messkreis 8 mit dem Isolationsüberwachungsgerät IMD geschlossen und damit das Isolationsüberwachungsgerät IMD zwischen aktiven Leitern L1, L2 und dem Schutzleiter PE verbleibt. Erfindungsgemäß ist daher in dem Isolationsüberwachungsgerät IMD eine Unterbrechervorrichtung 10 angeordnet, durch die der Messkreis 8 aufgetrennt werden kann, so dass der Innenwiderstand Zᵢ des Isolationsüberwachungsgerätes IMD nicht wirksam wird. Im Rahmen der Erst- und/oder der Wiederholungsprüfung kann der tatsächliche Gesamtisolationswiderstand R_{Fges} daher ohne Verfälschung durch den Innenwiderstand Zᵢ des Isolationsüberwachungsgerätes IMD ermittelt werden.

Zur Initiierung der Auftrennung des Messkreises 8 durch eine manuelle Schalthandlung ist an dem Isolationsüberwachungsgerät IMD eine Eingabevorrichtung 12 zur vorgesehen. Aus Sicherheitsgründen kann dabei als Schaltinformation die Eingabe einer bestimmten Zeichenfolge über eine Tastatur oder einen berührungsempfindlichen Bildschirm erforderlich sein. Die Schalthandlung kann auch von entfernter Stelle vorgenommen werden und mittels Signalübertragung zu dem Isolationsüberwachungsgerät IMD übertragen werden, das in diesem Fall eine Schnittstelle 14 zum Empfang des externen Signals aufweist.

Eine Signal- und Steuereinheit 16 signalisiert den aktuellen Anschlusszustand des Isolationsüberwachungsgerätes (Messkreis geschlossen/aufgetrennt) und weist somit auf ein infolge eines aufgetrennten Messkreises 8 momentan nicht isolations-überwachtes IT-Stromversorgungssystem 2 hin. Weiterhin kann die die Signal- und Steuereinheit 16 ein automatisches Schließen des Messkreises (8), beispielsweise in Verbindung mit einer programmierbaren Zeitspanne, ermöglichen.

Da die Messung des tatsächlichen Gesamtisolationswiderstands R_{Fges} in abgeschaltetem Zustand des IT-Stromversorgungssystems 2 erfolgt, weist das Isolationsüberwachungsgerät IMD einen in diesem Beispiel als Batterie ausgeführten elektrischen Energiespeicher 18 auf, um auch in spannungslosem Zustand des Isolationsüberwachungsgeräts IMD eine Auftrennung des Messkreises 8 durchführen zu können.

## Patentansprüche

1. Isolationsüberwachungsgerät (IMD), welches zwischen aktiven Leitern (L1, L2) eines IT-Stromversorgungssystems (2) und einem Schutzleiter (PE) angeschlossen ist und zur Überwachung eines Isolationswiderstands (R_{F}) mit dem ungeerdeten IT-Stromversorgungssystem (2) einen Messkreis (8) ausbildet,
**gekennzeichnet durch**
eine in dem Isolationsüberwachungsgerät (IMD) angeordnete Unterbrechervorrichtung (10) zur Auftrennung des Messkreises (8).

2. Isolationsüberwachungsgerät (IMD) nach Anspruch 1,
**dadurch gekennzeichnet,**
**dass** die Unterbrechervorrichtung (10) als Schaltmittel einen Relaiskontakt oder ein elektronisches Halbleiter-Schaltelement aufweist.

3. Isolationsüberwachungsgerät (IMD) nach Anspruch 2,
**dadurch gekennzeichnet,**
**dass** das Schaltmittel der Unterbrechervorrichtung (10) redundant ausgeführt ist.

4. Isolationsüberwachungsgerät (IMD) nach einem der Ansprüche 1 bis 3,
**gekennzeichnet durch**
eine Eingabevorrichtung (12) zur manuellen Eingabe einer Schaltinformation, die die Auftrennung und/oder ein Schließen des Messkreises (8) **durch** die Unterbrechervorrichtung (10) veranlasst.

5. Isolationsüberwachungsgerät (IMD) nach einem der Ansprüche 1 bis 4,
**gekennzeichnet durch**
eine Schnittstelle (14) für die Übertragung eines externen Signals zur Auftrennung und/oder zum Schließen des Messkreises (8) **durch** die Unterbrechervorrichtung (10).

6. Isolationsüberwachungsgerät nach einem der Ansprüche 1 bis 5,
**gekennzeichnet durch**
einen elektrischen Energiespeicher (18).

7. Isolationsüberwachungsgerät (IMD) nach Anspruch 6,
**dadurch gekennzeichnet,**
**dass** der elektrische Energiespeicher (18) als Kondensator oder als Batterie ausgeführt ist.

8. Isolationsüberwachungsgerät (IMD) nach einem der Ansprüche 1 bis 7,
**gekennzeichnet durch**
eine Signal- und Steuereinheit (16), die den aufgetrennten Zustand des Messkreises (8) signalisiert.

9. Isolationsüberwachungsgerät (IMD) nach Anspruch 8,
**dadurch gekennzeichnet,**
**dass** die Signal- und Steuereinheit (16) derart ausgeführt ist, dass sie ein automatisches Schließen des Messkreises (8) bewirkt.

10. Verfahren zur Durchführung einer Erst- und Wiederholungsprüfung eines Isolationswiderstands (R_{F}) in einem ungeerdeten IT-Stromversorgungssystem (2) sowie zur Überwachung des Isolationswiderstands (R_{F}) mit einem Isolationsüberwachungsgerät (IMD), welches zwischen aktiven Leitern (L1, L2) des IT-Stromversorgungssystems (2) und einem Schutzleiter (PE) angeschlossen ist, umfassend die Verfahrensschritte:
Durchführen der Erst- und/oder Wiederholungsprüfung, wobei ein aus dem Isolationsüberwachungsgerät (IMD) und dem IT-Stromversorgungssystem (2) gebildeter Messkreis (8) aufgetrennt wird, und
Überwachen des Isolationswiderstands (R_{F}) durch das Isolationsüberwachungsgerät (IMD), wobei der Messkreis (8) geschlossen ist,
**dadurch gekennzeichnet,**
**dass** zur Durchführung der Erst- und/oder Wiederholungsprüfung die Auftrennung des Messkreises (8) durch eine manuelle Schalthandlung erfolgt, die eine in dem Isolationsüberwachungsgerät (IMD) angeordnete Unterbrechervorrichtung (10) aktiviert.

11. Verfahren nach Anspruch 10,
**dadurch gekennzeichnet,**
**dass** die manuelle Schalthandlung durch Eingabe einer Schaltinformation an dem Isolationsüberwachungsgerät (IMD) erfolgt.

12. Verfahren nach Anspruch 11,
**dadurch gekennzeichnet,**
**dass** die manuelle Schalthandlung entfernt mit einem Signal erfolgt, das über eine Schnittstelle (14) von dem Isolationsüberwachungsgerät (IMD) empfangen wird.

13. Verfahren nach einem der Ansprüche 10 bis 12,
**dadurch gekennzeichnet,**
**dass** der aufgetrennte Zustand des Messkreises (8) signalisiert wird.

14. Verfahren nach einem der Ansprüche 10 bis 13,
**dadurch gekennzeichnet,**
**dass** ein automatisches Schließen des Messkreises (8) erfolgt.
